# EUROPEAN PATENT APPLICATION

(11) **EP 2 249 352 A1**
(43) Date of publication of application: **10.11.2010**
(21) Application number: 09159459.8
(22) Date of filing: 05.05.2009
(51) Int. Cl.: G11C 16/02, G11C 17/16, G11C 16/22

(54) **Phase change memory**

(71) Applicant: NXP B.V., 5656 AG Eindhoven (NL)
(72) Inventor: Cuppens, Roger, Redhill, Surrey RH1 1DL (GB); Storms, Maurits, M,N, Redhill, Surrey RH1 1DL (GB)
(74) Representative: Williamson, Paul Lewis

(57) **Abstract**

A phase change memory is operated by driving a current through selected phase change memory elements (16) sufficient to drive the phase change memory element to a high resistance amorphous state with a material threshold voltage above the operation voltage of the phase change memory so that the selected phase change memory elements are irreversibly programmed. Other phase change memory elements may be operated reversibly.

## Description

The invention relates to a phase change memory and a method of programming it.

The phase change memory is a non-volatile memory that is widely touted as a potential successor to flash memory. Typically, a resistor made of chalcogenide material is used as a phase change memory element to store the data; the resistor is programmed by phase change of the chalcogenide material. The material can be changed from crystalline to amorphous or vice versa by heating, which can be done by forcing current through the resistor. An alloy of Germanium, Antimony and Tellurium may be used as the chalogenide material. The phase change memory elements are arranged in an array.

Each memory cell typically also includes a switching/selecting element such as a transistor to select the phase change memory element in the memory array. The switching element can be a diode, bipolar transistor or MOS transistor. In a CMOS application, a n-MOST is a suitable switching element.

To switch the resistor from a crystalline low resistance state to an amorphous high resistance state a current is forced through the resistor which is large enough to locally melt the resistor. During fast cooling of the melted material the material becomes amorphous resulting in a high resistance resistor. Typically, this is called a "reset operation".

To switch the resistance from the amorphous high resistance state to the low resistance state a voltage larger than a voltage threshold, which is material dependent, is applied across the resistor in the amorphous high resistance state. This reduces the resistance and some current flows to heat the material and let it crystallise. This current needs to be lower than in the reset operation to avoid melting the material. This operation is typically known as a "set" operation.

For reading, a voltage lower than the material threshold voltage of the set mode is applied across the resistor and the current sensed to determine if a one or zero is stored in the cell.

However, since such memories can be rewritten the data stored in the memory can be changed. Where such memories are used to store program code, this can result in the possibility of "hacking", i.e. non-authorised changes to the program code or engineering the stored code.

According to the invention, there is provided a method of operation of a phase change memory according to claim 1.

By ensuring that some parts of the memory cannot be changed, these parts of the memory are difficult or impossible to change, without wiping the complete memory. Accordingly, memories operated according to the invention can have a greater resistance to hacking.

This is achieved without the use of a one-time programmable memory for the whole memory. Accordingly, other parts of the memory can be reused as required.

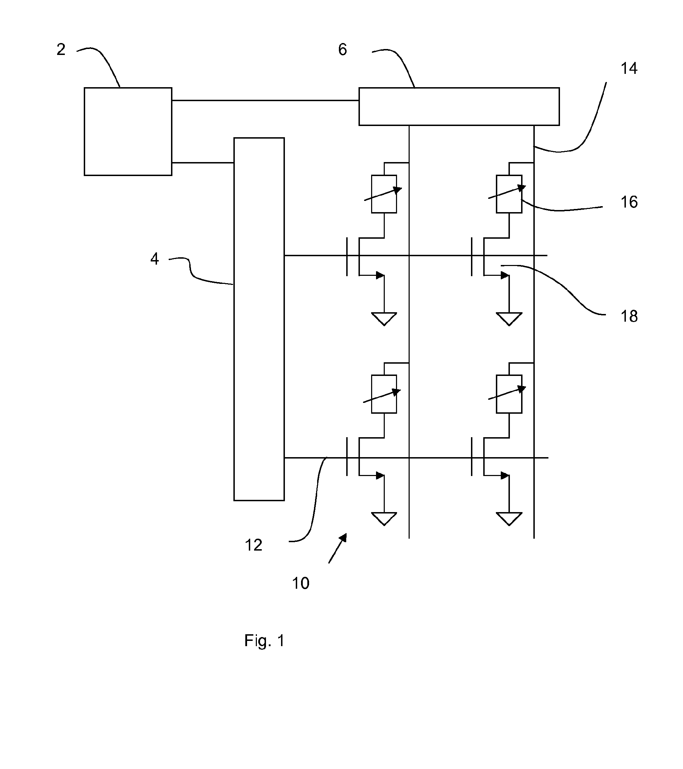

For a better understanding of the invention, an embodiment will now be described with reference to the Figure, which shows a circuit diagram of a phase change memory.

The Figure is schematic and not to scale.

Referring to the Figure, a phase change memory according to the invention has driver control circuitry 2 controlling word line drivers 4 and bit line drivers 6 arranged around a phase change memory cell array 10. The bit line drivers 6 can also include bit line selection means.

The memory array has a plurality of word lines 12 extending across the array in parallel, perpendicular to a plurality of bit lines 14 which again extend across the array in parallel. A phase change memory resistor 16 is provided at each crossing point. Each phase change memory element 16 is connected between a bit line and a selection element 18 to form a memory cell. In the embodiment the selection element is an n-type CMOS FET having its drain connected to the other node of the phase change resistor connected to the bit line 14, the source being connected to a common voltage and the gate being connected to a word line 12.

In the embodiment, any position in the phase change memory can be changed from a conventional phase change type memory element state, able to operate in two states or to a one time programmable state where the memory element cannot subsequently change, at least in normal operation.

This is achieved by controlling the voltage threshold so that it is higher than the supply voltage level for those cells in a one-time programmable state. By increasing the time or the current in a reset operation a larger melted area is achieved, and so the resulting amorphous region is larger. This increases both the resistance of the amorphous region and the threshold voltage. A threshold voltage above the normal supply voltage will be referred to below as an "irreversible material threshold voltage" since elements in this state are irreversible.

By increasing the threshold voltage above or below the normal supply voltage the individual cell can in this way be programmed to behave as a one time programmable cell, or as a multiple time programmable cell. The normal drive electronics cannot set the first type of cell since they cannot deliver the necessary voltage. The high resistance state can only be forced back to a low resistance state, in a set operation, by heating the chip above the crystallization temperature. This destroys all data in the memory. Alternatively, the phase change link can be completely broken by melting eliminating each set possibility.

Note that the embodiment programs cells into a fixed high resistance state, not the low resistance state. At first sight, this would seem to be a difficulty, since writing data requires both 1s and 0s. However, the inventor has appreciated that attempts to write new data to regions of the memory keeping the high resistance state unchanged and changing the low resistance, will simply result in garbled data. It will not be possible to completely reprogram the memory at will to carry out new functionality, so hacking and reengineering of existing products will be prevented. In some cases it is even possible to completely block the writing to some part of the memory based on the high resistance in some cells.

After processing or testing a new device, all cells are in a low resistance crystalline (set) initial state (or erased state). In the event that any cells are not, they are forced into this initial state by a normal set operation.

To write one-time programmable data in a memory element, firstly that memory element is selected using appropriate voltages on word and bit lines.

Then, a current is forced through the memory element. The current may be larger than the normal reset current, a longer time may be used than the normal reset current time, or both. In this way, a high resistance state is generated with a threshold voltage above that of the normal supply voltage which cannot then be set except by heating the complete device which erases all data.

Alternatively, if a sufficiently high current and time is used, the phase change link can be completely broken. Such a broken link will retain data even if the complete device is heated. Since the dimensions of the link are small and the link can be hidden under interconnect layers it will be very difficult and costly to identify cells with a broken link, since it would be first necessary to remove the interconnect layers and so destroy the chip.

The method according to the embodiment accordingly allows data to be written that cannot be changed which accordingly can protect the non-volatile memory from unwanted reengineering or hacking. Other protections may of course be added to increase protection levels.

In addition to writing some cells to have a threshold voltage above the normal supply voltage, other cells may be written with a lower current and/or time to have a threshold voltage below the normal supply voltage. Such threshold voltages will be referred to as a "reversible material threshold voltage" since cells with such a threshold voltage can be reversed. Data can accordingly be written and rewritten as in a conventional device as required.

The driver control circuitry 2 may be arranged to cause the method described above to operate under the control of the internal driver circuitry. The driver control circuitry may have appropriate instructions coded in either hardware or software.

Alternatively, the method described above may be implemented during manufacture (wafer test) by driving the word line, bit line and common voltage to levels not achievable by the driver control circuitry afterwards during the normal operation in an application.

In this way, some memory elements in the array are effectively one-time programmable and the other memory cell elements operate as conventional phase change memory elements that can be reprogrammed in normal operation as required. The invention allows one-time programmable functionality and conventional phase change functionality to be provided in the same memory array.

In an alternative embodiment, for example for wafer testing, first data is written forcing some cells to a high resistance with a threshold voltage below the nominal supply (multi time programmable part). After this some cells are programmed to the high state with a threshold above the normal supply or until the link is broken (irreversible state). These bits can than be used to block writing to some part of the matrix and/or to avoid external reading of the memory content.

In other words, in this embodiment, some cells are first written to a changeable (reversible) state, and subsequently data is written to an unchangeable (irreversible) state. This is the reverse of the order of writing in the first embodiment above.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A method of operation of a phase change memory having a plurality of phase change memory elements each switchable between a low resistance crystalline state and a high resistance amorphous state, the phase change memory having a predetermined normal supply voltage, the method comprising:
setting the phase change memory to an initial state with the phase change memory elements (16) in the low resistance crystalline state;
selecting at least one phase change memory element (16); and
driving a current through the at least one selected phase change memory element (16) to drive the at least one selected phase change memory element to a high resistance irreversible state.

2. A method according to claim 1 further comprising driving a current through other phase change memory elements (16) to reset the respective phase change memory elements to a high resistance amorphous state with a reversible material threshold voltage below the normal supply voltage.

3. A method according to claim 2, further comprising supplying a voltage above the reversible material threshold voltage to drive a current lower than the current in claim 2 to set at least one phase change memory element (16) to a low resistance crystalline state after it in one of the previous steps was driven with a current as claimed in 2..

4. A method according to claim 2 or 3 wherein the step of driving a current through other phase change memory elements to set the respective phase change memory elements to a high resistance amorphous state with a reversible material threshold voltage below the normal supply voltage takes place before the step of driving a current through the at least one selected phase change memory element to drive the at least one selected phase change memory element to a high resistance amorphous state with a irreversible material threshold voltage.

5. A method according to any preceding claim wherein the step of driving the current through the at least one selected phase change memory element drives the at least one selected phase change memory element to a high resistance amorphous state with an irreversible material threshold voltage above the normal supply voltage.

6. A method according to claim 5 when dependent upon claim 2, 3 or 4, wherein the step of driving a current through the at least one selected phase change memory element (16) includes driving a first current for a first time to drive the at least one selected phase change memory element to the high resistance amorphous state with the irreversible material threshold voltage above the normal supply voltage; the step of driving a current through other phase change memory elements includes driving a second current for a second time through the other phase change memory elements (16) to reset the respective phase change memory elements to a high resistance amorphous state with a reversible material threshold voltage below the normal supply voltage, and wherein the second time and/or the second current are less than the first time and/or the first current respectively.

7. A method according to any preceding claim wherein the step of driving a current through the at least one selected phase change memory element (16) includes driving a first current for a first time to drive the at least one selected phase change memory element to break the phase change memory element.

8. A phase change memory having a predetermined normal supply voltage comprising:
a plurality of phase change memory elements (16) each switchable between a low resistance crystalline state and a high resistance amorphous state, the phase change memory;
selection elements (18) for selecting respective phase change memory elements (16) and
driver control circuitry (2) adapted to drive the phase change memory by:
setting the phase change memory to an initial state with the phase change memory elements in the low resistance crystalline state;
driving at least one selection element (18) to select least one phase change memory element; and
driving a current through the at least one selected phase change memory element (16) to drive the at least one selected phase change memory element to an irreversible high resistance amorphous state.

9. Apparatus according to claim 8 further comprising:
word line drivers (4) for driving word lines (12);
bit line drivers (6) for driving bit lines (14);
wherein each selection element (18) is connected to a word line (12) to control the selection element (18) and each phase change memory element (16) is provided between a bit line (14) and a respective selection element (18);
the bit line drivers (6) are arranged to provide a first voltage to drive a first current for a first time to drive the at least one selected phase change memory element to a high resistance amorphous state with an irreversible material threshold voltage above the supply voltage;
and the bit line drivers (6) are further arranged to provide a second voltage to drive a second current for a second time through other phase change memory elements to set the respective phase change memory elements to a high resistance amorphous state with a reversible material threshold voltage below the normal supply voltage, wherein the second time and/or the second current and/or the second voltage are less than the first time, the first current and/or the first voltage respectively.

10. Apparatus according to claim 9 wherein the bit line drivers are further arranged to supply a voltage above the second material threshold voltage to set phase change memory element in a state with a low resistance crystalline state.
